# EUROPÄISCHE PATENTSCHRIFT

(11) **EP 2 140 486 B1**
(45) Veröffentlichungstag und Bekanntmachung des Hinweises auf die Patenterteilung: **31.08.2011**
(21) Anmeldenummer: 08709256.5
(22) Anmeldetag: 28.02.2008
(51) Int. Cl.: H01L 21/673, H01L 21/687, H01L 21/683

(54) **CARRIERSYSTEM UND VERFAHREN ZUM PROZESSIEREN EINER MEHRZAHL VON SUBSTRATEN, DIE AM CARRIERSYSTEM FIXIERT SIND**
CARRIER SYSTEM AND METHOD FOR PROCESSING A PLURALITY OF SUBSTRATES FIXED TO THE CARRIER SYSTEM
SYSTÈME DE SUPPORT ET PROCÉDÉ POUR TRAITER PLUSIEURS SUBSTRATS FIXÉS SUR CE SYSTÈME DE SUPPORT

(30) Priorität: 28.02.2007 DE 102007010710
(43) Veröffentlichungstag der Anmeldung: 06.01.2010
(73) Patentinhaber: Q-Cells SE, 06766 Bitterfeld-Wolfen (DE)
(72) Erfinder: MÜLLER, Jörg, 06792 Sandersdorf (DE); HLUSIAK, Markus, 06766 Wolfen (DE)
(74) Vertreter: Reininger, Jan Christian
(86) Internationale Anmeldenummer: PCT/EP2008/052444
(87) Internationale Veröffentlichungsnummer: WO 2008/104596

(56) Entgegenhaltungen:
- WO-A-02/20871
- WO-A-02/21579
- JP-A- 2005 340 499
- TOKUDA H ET AL: "Physicochemical properties and structures of room-temperature ionic liquids. 3. Variation of cationic structures" J. PHYS. CHEM. B, AMERICAN CHEMICAL SOCIETY, USA, Bd. 110, Nr. 6, 16. Februar 2006 (2006-02-16), Seiten 2833-2839, XP002480340
- YU ET AL: "Preparation of functional ionic liquids and tribological investigation of their ultra-thin films" WEAR, ELSEVIER SEQUOIA, LAUSANNE, CH, Bd. 260, Nr. 9-10, 31. Mai 2006 (2006-05-31), Seiten 1076-1080, XP005422541 ISSN: 0043-1648

## Beschreibung

Die vorliegende Erfindung betrifft ein Carriersystem gemäß dem Oberbegriff des Anspruchs 1 und ein Verfahren zum Prozessieren einer Mehrzahl von Substraten, die am Carriersystem fixiert sind, gemäß Anspruch 9.

Aus dem Stand der Technik sind für die Herstellung von Solarzellen auf Basis von Halbleiterwafer-Substraten so genannte Carriersysteme bekannt, die das gleichzeitige Prozessieren einer Mehrzahl von Substraten in Form von Halbleiterwafern in einer Prozessanlage ermöglichen. Derartige Carriersysteme kommen insbesondere für in-line-Produktionsanlagen, die bei der Massenproduktion von Solarzellen genutzt werden, zum Einsatz.

Aus der WO 02/21579 A ist eine Vorrichtung bekannt, mit der sich ein einzelner Halbleiterwafer als Substrat auf einem Carrier in Form eines so genannten Chucks fixieren und prozessieren lässt. Die JP 2005/340499 A zeigt ein Carriersystem, mit dem sich eine Mehrzahl von Substraten in Form prozessierter Halbleiterwafer gleichzeitig bewegen lassen.

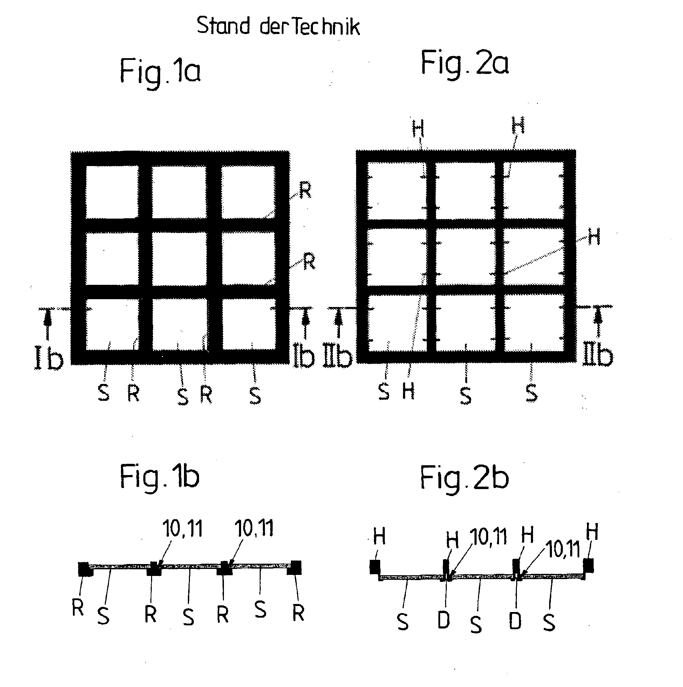

Zwei übliche Varianten eines Carriersystems 1 sind in den Figuren 1 a und 2a schematisch dargestellt. Es ist jeweils die Ansicht auf die zu prozessierenden Oberflächen neun quadratischer Halbleiterwafer S gezeigt, die in Form eines quadratischen 3x3 Rasters angeordnet sind.

Die erste Variante des Carriersystems 1 aus Figur 1a zeigt einen gitterartigen Aufbau, aus Graphitstegen R, die neun gleich große Öffnungen ausbilden, in die sich die Halbleiterwafer-Substrate S hinein legen lassen. In Figur 1b ist die Schnittansicht des Carriersystems 1 entlang der gestrichelt Linie in Figur 1 a dargestellt. Man erkennt zwei im Querschnitt T-förmig ausgebildete mittlere Stege R und zwei äußere Stege R, die einen L-förmigen Aufbau mit nach innen gerichtetem Schenkel aufweisen. Die horizontal verlaufenden Schenkel der Stege R bilden jeweils flächige Kontaktbereiche 10, auf denen ein Auflagebereich am Rand eines eingelegten Halbleiterwafers S zu liegen kommt. Die jeweils vertikal orientierten Abschnitte der Stege R wirken als Fixiermittel 11, die die Position der in das Carriersystem 1 gelegten Halbleiterwafer S sicherstellen. Figur 1 a zeigt die Unteransicht von neun in das Carriersystem 1 eingelegten Halbleiterwafern S. Die in einer Prozessanlage bearbeitbare Waferfläche entspricht bis auf den durch die Kontaktbereiche 10 der Stege R abgeschatteten umlaufenden Randbereich der Waferoberfläche.
Figur 2a zeigt eine zweite aus dem Stand der Technik bekannte Variante eines Carriersystems 1 in der Unteransicht entsprechend der Ansicht aus Figur 1 a.

Anders als bei der ersten Variante bilden hier stegförmige Hakenelemente H ein symmetrisches Gitter mit neun Öffnungen, in die sich Halbleiterwafer S einlegen lassen. Figur 2b zeigt entsprechend Figur 1b einen Schnitt entlang der gestrichelten Linie IIb-IIb durch das Carriersystem 1. Bei dieser Variante bilden die horizontal orientierten Schenkel L-förmiger Haken Kontaktbereiche 10, auf denen gegenüber liegende Kanten der in das Carriersystem 1 eingelegten Halbleiterwafer S jeweils paarweise zu liegen kommen. Zwischen den benachbart angeordneten Halbleiterwafern S bildet sich bei dieser Variante ein spaltförmiger Angrenzbereich D aus. Die Breite des Angrenzbereichs D ist hier im Wesentlichen durch die Dimensionierung der L-förmigen Haken bestimmt.

Beide bekannten Varianten des Carriersystems 1 weisen in den Figuren nicht dargestellte Haltevorrichtungen auf, mit denen sich die Carriersysteme 1 beim Prozessieren der Substrate in einer Prozessanlage räumlich derart anordnen lassen, dass die auf die Substrate wirkende Schwerkraft eine Kraftkomponente aufweist, die von dem jeweils zugeordneten Kontaktbereich 10 weg weist.

Die bekannten Carriersysteme haben den Nachteil, dass die Flächen der als Substrate eingesetzten Halbleiterwafer durch die als Fixiermittel wirkenden Stege teilweise abgedeckt werden. Diese Abdeckungen führen zu Inhomogenitäten der abgeschiedenen Schicht. Dies wiederum beeinflusst die optischen, ästhetischen oder elektrischen Eigenschaften negativ. Beim Prozessieren der Substrate in einer Prozessanlage wirkt der jeweilige Prozess auch auf die Abschnitte der Stege, die sich benachbart zu den Substratoberflächen befinden. Wird in der Prozessanlage ein Abscheideprozess für Dünnschicht- oder andere Beschichtungsanlagen gefahren, so scheidet sich auch Material auf den Stegen des Carriersystems ab. Da die Carriersysteme nach dem Durchlaufen einer Charge von Substraten wieder verwendet werden, ist eine regelmäßige Reinigung der Carriersysteme erforderlich, um unerwünschte Verunreinigungen durch Materialpartikel zu vermeiden, die von den Stegen abblättern können.

Aus der WO 02/20871 A ist ein Carriersystem bekannt, dessen struktureller Aufbau eine homogene Dünnschichtabscheidung ohne die Problematik von Abschattungen gewährleistet. Außerdem ist jeder Kontaktbereich auf einem zugeordneten Trägerelement vorgesehen. Nachteilig an den bekannten Carriersystemen ist jedoch, dass diese nicht für alle Schichtabscheideverfahren universell einsetzbar sind.

Der vorliegenden Erfindung liegt somit die Aufgabe zu Grunde, ein verbessertes Carriersystem zu schaffen, das die genannten Nachteile überwindet. Ferner liegt ein Aspekt der Erfindung in der Bereitstellung von Verfahren, die mit dem Carriersystem zur Prozessierung von Substraten durchgeführt werden. Ein weiterer Aspekt der Erfindung liegt in der Bereitstellung verbesserter Verfahren zur Herstellung von Halbleiterwafer-Solarzellen.

Diese Aufgabe wird gelöst durch ein Carriersystem mit den Merkmalen des Anspruchs 1. Betreffend ein Verfahren wird die Aufgabe durch ein Verfahren mit den Merkmalen des Anspruchs 9 gelöst.

Im Hinblick auf das Carriersystem ist erfindungsgemäß vorgesehen, dass das Trägerelement (12) zusammen mit dem Fixiermittel (11) als Wärmesenke für ein am Kontaktbereich (10) fixiertes Substrat (5) ausgebildet ist.

Dadurch lässt sich eine unerwünschte Überhitzung des Substrates vermeiden, die bei einigen Prozessen in den Prozessanlagen auftreten können. Die Funktionalität der Wärmesenke lässt sich beispielsweise durch eine ausreichende spezifische Wärmekapazität des Trägerelementes oder durch ein Kühlsystem des Trägerelementes mit einem gasförmigen oder einem flüssigen Wärmetransportmedium realisieren.

Beim Einsatz quadratischer oder rechteckiger Substrate lassen sich die Angrenzbereiche zwischen den Substraten minimieren. Gleichzeitig gewährleisten die Fixiermittel, dass die Lage der Substrate im Carriersystem entgegen einer durch die Schwerkraft verursachte Verschiebekraft unverändert bleibt.

Einerseits lässt sich auf diese Weise die Dichte der zu prozessierenden Substrate im Carriersystem maximieren, wobei sich die gesamte Oberfläche der Substrate ohne Abschattungen prozessieren lässt. Weiterhin wird das Carriersystem in geringerem Maße vom Prozess betroffen. Daher lassen sich höhere Standzeiten der Bauelemente des Carriersystems erreichen, bevor diese gereinigt oder ausgetauscht werden müssen.

Als Angrenzbereich zweier benachbart angeordneter Substrate wird im Sinne der vorliegenden Erfindung der Raumbereich verstanden, der durch das fiktive Verbinden der Außenkonturen zweier benachbart angeordneter Substrate umgeben wird. Die in einem Carriersystem fixierbaren Substrate sind für die in-line-Massenproduktion oftmals identisch und im Wesentlichen flächig ausgebildet. In einem solchen Fall entspricht der Angrenzbereich dem Raumabschnitt, der von einer fiktiven Verbindung des ersten Substrats mit dem zweiten Substrat durchgriffen würde.

Für die Massenproduktion kommen regelmäßig flächig ausgebildete Substrate, beispielsweise in Form quadratischer oder rechteckiger Halbleiterwafer, zum Einsatz., Entsprechend sind die Kontaktbereiche flächig in Form ebener quadratischer oder rechteckiger Flächen ausgebildet. Die Kontaktbereiche wirken als Auflagefläche, die im Vergleich zu den Flächen der Substrate kleiner oder gleich groß dimensioniert sind. Auf diese Weise lassen sich die Substrate jeweils über ihre nicht zu prozessierende Oberfläche mit Hilfe der Fixiermittel am Carriersystem befestigen.

Bevorzugt sind die flächigen Kontaktbereiche im Wesentlichen in einer gemeinsamen Kontaktebene angeordnet. Über die gemeinsame Kontaktebene lässt sich bei Substraten identischer Dicke eine gemeinsame Ebene der zu prozessierenden Substratoberflächen realisieren. Bei einer entsprechend ausgebildeten Prozessanlage sind auf diese Weise die Abstandsbedingungen für jedes bearbeitete Substrat mit Toleranzen von weniger als einem Millimeter gleich.

Für die vorangehende Ausführungsform des Carriersystems ist es von Vorteil, dass die Haltevorrichtung und die Fixiermittel zumindest im Bereich benachbarter Kontaktbereiche ausschließlich auf der Seite der Kontaktebene angeordnet sind, die von zu fixierenden Substraten weg weist. Dadurch lässt sich die unerwünschte Einwirkung des für die Bearbeitung der Substrate vorgesehenen Prozesses auf das Carriersystem verringern. Dieser Effekt wird dadurch erzielt, dass die auf dem Carriersystem fixierten Substrate mit ihren zu prozessierenden Substratoberflächen die Bauelemente des Carriersystems vor Einwirkungen der Prozessanlage weitestgehend abschatten.

Bei der Massenproduktion sind die eingesetzten Substrate regelmäßig gleich dimensioniert. Bevorzugt sind daher die Kontaktbereiche des Carriersystems im Wesentlichen gleich ausgebildet.

Weiterhin ist es von Vorteil, das Carriersystem derart auszubilden, dass die Kontaktbereiche für die zu fixierenden Substrate in einer Raumrichtung oder in zwei Raumrichtungen periodisch angeordnet sind. Dadurch wird ein einfacherer Aufbau des Carriersystems erzielt, weil sich die Kontaktbereich-Strukturen räumlich wiederholen. Für den Fall, dass das Carriersystem modular aufgebaut ist, lassen sich die Module räumlich periodisch miteinander koppeln. Weiterhin ist es möglich, eine Mehrzahl von Carriersystemen derart auszubilden, dass die Carriersysteme unter Beibehaltung der Kontaktbereich-Periodizität miteinander koppelbar sind.

Um den Wärmeübergang von der zu prozessierenden Substratoberfläche zu dem als Wärmesenke wirkenden Trägerelementes zu optimieren, ist es von Vorteil, dass die Kontaktbereiche ein Flächenmaß aufweisen, das im Wesentlichen der Substratfläche der an den Kontaktbereichen zu fixierenden Substrate entspricht. Weiterhin bevorzugt weist das Trägerelement aus der Blickrichtung eines zu fixierenden Substrates im Wesentlichen die gleiche oder eine kleinere Ausdehnung auf, wie ein zu fixierendes Substrat. Dadurch wird gewährleistet, dass die Minimierung des Angrenzbereiches zwischen zu fixierenden Substraten nicht durch die Ausdehnung des Trägerelementes beschränkt ist.

Eine vorteilhafte Ausführungsform sieht vor, jedes Trägerelement als separates Bauelement auszubilden und dass die Haltevorrichtung des Carriersystems an jedem Trägerelement Koppelmittel zur mechanischen Kopplung der einzelnen Trägerelemente aufweist. Dadurch weist das Carriersystem einen modularen Aufbau aus einzelnen Trägerelementen auf. Eine bevorzugte Variante dieser Ausführungsform ist dadurch gekennzeichnet, dass die Trägerelemente geradlinige Begrenzungskanten derart aufweisen und die Trägerelemente mit den Begrenzungskanten zueinander benachbart derart angeordnet sind, dass sich zwischen den Begrenzungskanten ein Spaltmaß von weniger als 5mm, bevorzugt von weniger als 2mm ausbildet. Jedes Trägerelement ist beispielsweise als Block mit einer quadratischen Grundform aufgebaut. Die quadratische Grundform weist beispielsweise Begrenzungskanten von 156mm x 156mm auf. Durch die geradlinigen Begrenzungskanten lassen sich die Trägerelemente auf einfache Weise miteinander kombinieren und koppeln.

Eine bevorzugte Weiterbildung des vorangehend beschriebenen Carriersystems mit Trägerelementen sieht vor, dass auf der von den Substraten abgewandten Seite der Trägerelemente entlang der Begrenzungskanten Auffangeinrichtungen angeordnet sind, die gasförmiges Depositionsmaterial aufnehmen, das zwischen den Begrenzungskanten aufsteigt, derart, dass die Auffangeinrichtung das gasförmige Depositionsmaterial von der Halteeinrichtung mit den Koppelmitteln fern hält. Die Auffangeinrichtungen müssen aus Werkstoffen gebildet sein, die den spezifischen Umgebungsbedingungen des Bearbeitungsprozesses der Substrate standhält. Bevorzugt handelt es sich bei den Auffangeinrichtungen um preisgünstige Blechmasken, die ersetzt werden, bevor ihre Substanz zu stark vom Bearbeitungsprozess beeinträchtigt ist.

Die als Bestandteil des Carriersystems vorgesehenen Fixiermittel können als Adhäsionsfolie ausgebildet sein. Die dafür zum Einsatz kommenden Polymere müssen insbesondere für die thermischen Randbedingungen der Prozesse angepasst sein, bei denen das Carriersystem zum Prozessieren der daran fixierten Halbleiterwafer zum Einsatz kommen soll. Aus dem Stand der Technik sind hier eine Reihe geeigneter Polymere bekannt, die sich insbesondere durch gute Wärmeleitungseigenschaften auszeichnen. Dies ist für die Ausbildung des Carriersystems mit als Wärmesenken wirkenden Trägerelementen von Vorteil. Die zum Substrat gewandte Oberfläche der Adhäsionsfolie wirkt somit als Kontaktbereich des Carriersystems.

Ein Beispiel für eine geeignete Adhäsionsfolie aus Polyimid stellt das unter dem Markenname Kapton ® durch die Firma DuPont, Wilmington/USA vertriebene Folienprodukt dar. Diese kann in Kombination mit einer Klebeschicht, beispielsweise aus einem Polysiloxankleber eingesetzt werden.

Als eine weitere Variante weisen die Fixiermittel alternativ oder kumulativ ein weiches oder flüssiges Klebemittel beispielsweise in Form eines Vakuumfettes oder einer ionischen Flüssigkeit auf. Im Zusammenhang mit geeigneten ionischen Flüssigkeiten, insbesondere für die thermische Kopplung zwischen Substrat und Wärmesenke in Form eines Trägerelementes ist auf die Ausführungen in der deutschen Patentanmeldung DE 10 2007 006 455 der Anmelderin verwiesen.

Ionische Flüssigkeiten sind Flüssigkeiten, die ausschließlich aus Ionen bestehen. Es handelt sich um flüssige Salze, ohne dass das Salz dabei in einem Lösungsmittel wie beispielsweise in Wasser gelöst ist. Es ist eine Vielzahl entsprechender Verbindungen bekannt, die beispielsweise im Bereich von 20°C bis 200°C im flüssigen Aggregatzustand vorliegen. Ausgehend von den Prozess-Parametern, die beim Carriersystem zum Prozessieren eines Substrates vorherrschen, lässt sich eine ionische Flüssigkeit mit passenden physikalischen Eigenschaften auswählen. Die Bandbreite an zur Verfügung stehenden unterschiedlichen ionischen Flüssigkeiten bringt den Vorteil der flexiblen Einsatzmöglichkeit des Carriersystems für eine Vielzahl von Bearbeitungsprozessen mit sich.

Eine Variante des Carriersystems sieht vor, dass die Fixiermittel eine ionische Flüssigkeit aufweisen. Zum einen können die Fixiermittel ausschließlich aus einer einzigen ionischen Flüssigkeit oder aus einer Mischung unterscheidbarer ionischer Flüssigkeiten bestehen. Zum anderen ist ebenso denkbar, dass die Fixiermittel lediglich als ein Bestandteil zumindest eine ionische Flüssigkeit aufweisen. Beispielsweise könnte eine Trägermatrix vorgesehen sein, die eine ionische Flüssigkeit beziehungsweise eine Mischung ionischen Flüssigkeiten ähnlich wie ein Schwamm aufnimmt. Die Fixiermittel umfassen dann eine Kombination der Trägermatrix mit der oder den ionischen Flüssigkeiten. Beide Varianten können den Vorteil einer unkomplizierten Handhabung und der Kostenersparnis mit sich bringen.

Für den Einsatz des Carriersystems in üblichen Prozessanlagen ist es vorteilhaft ionische Flüssigkeiten einzusetzen, die oberhalb von 100°C, bevorzugt oberhalb von 150°C, besonders bevorzugt oberhalb von 200°C, thermisch stabil sind. Auf diese Weise lässt sich vermeiden, dass Zerfallsprodukte der ionischen Flüssigkeit in Wechselwirkung mit ihrer Umgebung treten können.

Viele Prozesse zum Prozessieren von Substraten finden unter Vakuumbedingungen statt. Dafür ist es vorteilhaft, dass die ionische Flüssigkeit bei 25°C einen Dampfdruck unterhalb 0,1 Pa, bevorzugt unterhalb von 0,01 Pa und besonders bevorzugt unterhalb von 0,001 Pa aufweist. Dadurch wird gewährleistet, dass die ionische Flüssigkeit unter Vakuumbedingungen keinen signifikanten Einfluss auf das Prozessieren der am Carriersystem fixierten Substrate nimmt.

Vorteilhaft ist die ionische Flüssigkeit aus einem Anion und einem Kation gebildet, wobei das Anion Bis(trifluormethylsulfonyl)amid ist, und das Kation ausgewählt ist aus der Gruppe, bestehend aus wahlweise substituiertem Alkylimidazolium, Tetraalkylammonium, wahlweise substituiertem Dialkylpiperidinium und deren Mischungen. Alkyl bedeutet ein wahlweise substituierter Kohlenwasserstoff. Die Alkylreste des Tetraalkylammoniums können gleich oder verschieden sein. Die Alkylreste des Dialkylpiperidiniums können ebenfalls gleich oder verschieden sein. Im Sinne der vorliegenden Erfindung schließt der Ausdruck "wahlweise substituiert" wahlweise keinen Substituenten oder mindestens einen Substituenten ein, der einen Kohlenwasserstoff mit 1 bis 3 Kohlenstoffatomen oder OH umfasst, aber nicht darauf beschränkt ist. Das Kation ist bevorzugt ausgewählt aus der Gruppe, bestehend aus 1-Ethyl-3-methyl-imidazolium, N-Methyl-N-trioctylammonium, 1-Methyl-1-propyl-piperidinium. Bevorzugter ist die ionische Flüssigkeit 1-Methyl-1-propylpiperidinium bis(trifluormethylsulfonyl)amid.

Wiederum alternativ oder kumulativ zu den vorangehend beschriebenen Varianten der Adhäsionsfolie und/oder des weichen oder flüssigen Klebemittels ist das Carriersystem in einer weiteren vorteilhaften Variante derart ausgebildet, dass die Fixiermittel eine auf zu fixierende Substrate elektrostatisch wirkende Fixiervorrichtung aufweisen. Elektrostatisch wirkende Fixiervorrichtungen sind aus dem Stand der Technik insbesondere für das Prozessieren so genannter ultradünner Halbleiterwafer bekannt. Dabei wird der Kontaktbereich durch eine dünne dielektrische Schicht gebildet, unter der sich eine Elektrodenanordnung mit mindestens zwei Elektrodensystemen befindet. Zwischen den beiden Elektrodensystemen wird eine Potentialdifferenz angelegt, die zur Ausbildung eines elektrischen Feldes führt. Dieses Feld durchgreift insbesondere das auf dem Kontaktbereich angeordnete Substrat und führt in diesem zu einer am Feld orientierten Ausrichtung von Raumladungen. Auf diese Weise entsteht eine auf das Substrat wirkende Anziehungskraft, die zumindest teilweise in Richtung des Kontaktbereiches orientiert ist.

Eine weitere vorteilhafte Ausführungsform des Carriersystems ist dadurch gekennzeichnet, dass in den Kontaktbereichen eine Vielzahl von Öffnungen mit sich daran anschließenden Kanälen derart vorgesehen ist, dass bei einem Evakuieren der Umgebung des Carriersystems Gaseinschlüsse zwischen zu fixierenden Substraten und den Kontaktbereichen über die Kanäle ableitbar sind. Dadurch wird verhindert, dass der innige mechanische Kontakt zwischen den fixierten Substraten und dem Kontaktbereich während des Evakuierens der Umgebung des Carriersystems in einer Prozessanlage beeinträchtigt wird.

Eine weitere bevorzugte Ausführungsform sieht in den Kontaktbereichen mindestens eine Saugöffnung mit daran anschließendem Saugkanal derart vor, dass sich ein zu fixierendes Substrat, das mit dem Kontaktbereich in Kontakt steht, durch das Anlegen eines Unterdruckes im Saugkanal auf den Kontaktbereich aufpressen lässt.

Ein weiterer wichtiger Aspekt der Erfindung besteht darin, ein verbessertes Verfahren zur Herstellung von Solarzellen bereitzustellen.

Erfindungsgemäß sind folgende Verfahrensschritte vorgesehen, Bereitstellen einer Mehrzahl flächiger Substrate mit quadratischer oder rechteckiger Substratoberfläche, Bereitstellen eines Carriersystems mit Merkmalen gemäß den vorangehenden Ausführungen, Fixieren der Substrate auf den zugeordneten Kontaktbereichen des Carriersystems, Bereitstellen des Carriersystems einschließlich fixierter Substrate in der Prozessanlage, wobei das Carriersystem über die Haltevorrichtung derart orientiert ist, dass die auf die Substrate wirkende Schwerkraft eine Kraftkomponente aufweist, die von dem jeweils zugeordneten Kontaktbereich weg weist, Prozessieren der Substrate in der Prozessanlage und abschließendes Lösen der Substrate von den zugeordneten Kontaktbereichen, wobei die Substrate als Halbleiterwafer mit einem p-n-Übergang für eine Solarzelle bereitgestellt werden und der Verfahrensschritt des Prozessierens der Substrate entweder in einer ersten Verfahrensalternative
als Beschichtung einer Seite jedes Halbleiterwafers mit einer elektrisch leitfähigen Schicht, bevorzugt einer Aluminiumschicht, ausgebildet ist oder
in einer zweiten Verfahrensalternative als Beschichtung einer Seite jedes Halbleiterwafers mit einer SiN-Dünnschicht in einer als Sputter- oder PECVD-Anlage ausgebildeten Prozessanlage durchgeführt wird.

Für beide Verfahrensatternativen sind alle bekannten Varianten von p-n-Übergängen auf Halbleiterwafern denkbar: großflächige Übergänge, die sich über eine komplette Oberfläche des Halbleiterwafers erstrecken, auf der Waferoberfläche streifen- bzw. punktförmig lokalisierte p-n-Übergänge oder p-n-Übergänge, die sich von der einen zur anderen Seiten des Halbleiterwafers erstrecken.

Für die erste Verfahrensalternative der abgeschiedenen elektrisch leitfähigen Schicht weist diese eine Stärke im Bereich von 5µm bis 20µm, bevorzugt 10µm bis 15µm auf. Bei diesen Schichtdicken entstehen insbesondere beim Abscheiden von Aluminium aus der Gasphase signifikante Kondensationsenthalpien. Damit die Halbleiterwafer durch die Hitzebildung nicht beschädigt oder verformt werden, ist es erforderlich, die Wärmeableitung vom Substrat über die Kontaktbereich zu optimieren. Dies erfolgt einerseits durch die vorangehend beschriebene Angleichung von Substratoberfläche und Kontaktbereich. Außerdem muss der Kontaktbereich auch unter Vakuumbedingungen eine ausreichende Wärmeleitung weg vom Substrat in das Carriersystem hinein gewährleisten. Wenn die gewünschten Abscheideraten erhöht werden sollen, muss die Wärmeleitfähigkeit bzw. die Kapazität der Wärmesenke entsprechend angepasst werden. Diese Ausführungen gelten entsprechend für alle nachfolgend beschriebenen Varianten zur Realisierung von Solarzellen-Elektrodenstrukturen.

Für die zweite Verfahrensalternative wird der Verfahrensschritt des Prozessierens der Substrate als Beschichtung einer Seite jedes Substrates mit einer SiN-Dünnschicht in einer als Sputter- oder PECVD-Anlage ausgebildeten Prozessanlage durchgeführt. Die SiN-Dünnschicht fungiert als Antireflexionsschicht, die noch vor dem Aufbringen einer Elektrodenschicht abgeschieden werden muss. Auf die SiN-Dünnschicht wird in einer Variante mittels eines Druckschrittes, beispielsweise durch ein Siebdruckverfahren oder ein anderes Druckverfahren, eine Elektrodenstruktur aufgebracht, die anschließend mittels eines thermischen Verfahrensschrittes in die Oberfläche eingebrannt wird.

Alternativ wäre es ebenso denkbar, eine elektrisch leitfähige Schicht wie vorangehend beschrieben zur Bildung von Elektrodenstrukturen im Anschluss an die Herstellung der SiN-Schicht abzuscheiden. Dabei wäre es denkbar, das gleiche Carriersystem bei der Abscheidung der SiN-Dünnschicht und der elektrisch leitfähigen Schicht einzusetzen.

Eine bevorzugte Variante beider Verfahrensalternativen sieht vor, dass die Halbleiterwafer derart fixiert werden, dass die Angrenzbereiche zwischen den Halbleiterwafern auf eine Breite von kleiner 5 mm, bevorzugt kleiner 1 mm minimiert werden. Auf diese Weise lässt sich eine Wechselwirkung des Prozesses in einer Prozessanlage auf das Carriersystem verringern, weil die zu prozessierenden Halbleiterwafer das hinter den Halbleiterwafern angeordnete Carriersystem weitgehend abschirmen.

Bevorzugt werden im Wesentlichen identische Halbleiterwafer bereitgestellt, was eine weitere Rationalisierung der Herstellung ermöglicht.

Der Verfahrensschritt des Prozessierens der Halbleiterwafer ist bevorzugt als ein Prozess oder eine Kombination von Prozessen aus der Vakuumtechnologie ausgebildet und das Prozessieren der Substrate im Vakuum wird bei einem Druck von unter 500 Pa, bevorzugt von unter 1 Pa und besonders bevorzugt von unter 0,01 Pa durchgeführt. Unter den Sammelbegriff "Prozesse aus der Vakuumtechnologie" fallen sämtliche zum Stand der Technik bekannten Verfahren, wie z.B. Chemical Vapor Deposition (CVD), Plasma Enhanced CVD (PECVD); Physical Vapor Deposition (PVD), insbesondere Sputtern, Hochraten-Elektronenstrahl-Aufdampfen, thermisches Aufdampfen; Ätzverfahren wie Plasmaätzen, Reactive Ion Etching (RIE), lonenimplantation etc.
Im Druckbereich von 500 Pa bis zirka 1 Pa wird üblicherweise für Verfahren zur chemischen Gasphasenabscheidung (CVD) und im Bereich von unter 1 Pa für Verfahren zur physikalischen Gasphasenabscheidung (PVD) gearbeitet.

Eine bevorzugte Weiterbildung der ersten Verfahrensalternative zur Herstellung von Halbleiterwafer-Solarzellen sieht vor, dass die Substrate in Form von Halbleiterwafern mit einer auf einer ersten Seite der Halbleiterwafer angeordneten ersten Elektrodenstruktur bereitgestellt werden, wobei die elektrisch leitfähige Schicht als zweite Elektrodenstruktur auf der zweiten Seite des Halbleiterwafers abgeschieden wird, um eine Halbleiterwafer-Solarzelle zu bilden.

Eine weitere vorteilhafte Abwandlung der ersten Verfahrensalternative ist derart ausgebildet, dass die elektrisch leitfähige Schicht mittels eines Strukturierungsschrittes in eine erste Elektrodenstruktur und in eine zweite Elektrodenstruktur strukturiert wird, um eine Halbleiterwafer-Solarzelle zu bilden. Die beiden Elektrodenstrukturen sind dabei als kammförmig ineinander greifende Strukturen ausgebildet.

Die vorangehend beschriebenen Verfahren sind bevorzugt zur Herstellung von Solarmodulen derart weitergebildet, dass eine Mehrzahl von Halbleiterwafer-Solarzellen elektrisch miteinander gekoppelt, auf einem Trägerelement fixiert und gegenüber Umwelteinflüssen mittels Glasscheiben und/oder Folien und/oder Rahmenelementen verkapselt werden, derart, dass aus der Mehrzahl von Halbleiterwafer-Solarzellen ein Solarmodul gebildet wird.

Weitere Eigenschaften und Vorteile der Erfindung werden im Zusammenhang mit den in den folgenden Figuren dargestellten bevorzugten Ausführungsformen erläutert.

Es zeigt:
- Figur 1 a: eine schematische Darstellung einer ersten Variante eines aus dem Stand der Technik bekannten Carriersystems;
- Figur 1 b: eine schematische Schnittansicht entlang der Linie Ib-Ib in Figur 1 a;
- Figur 2a: eine schematische Darstellung einer zweiten Variante eines aus dem Stand der Technik bekannten Carriersystems;
- Figur 2b: eine schematische Schnittansicht entlang der Linie IIb-IIb in Figur 2a;
- Figur 3a: eine schematische Darstellung einer bevorzugten Ausführungsform des erfindungsgemäßen Carriersystems in einer Ansicht der Unterseite gemäß der Ansichtrichtung aus den Figuren 1 a und 2a;
- Figur 3b: eine schematische Ansicht der Oberseite des in Figur 3a gezeigten Carriersystems;
- Figur 3c: eine nicht maßstabsgerechte, schematische Schnittansicht des Carriersystems aus Figur 3b entlang der Linie IIIc-IIIc;
- Figur 4: eine vergrößerte Darstellung eines Ausschnitts der Schnittdarstellung aus Figur 3c;
- Figur 5a: eine erste Variante einer vergrößerten Darstellung des mit Va bezeichneten Teilbereichs aus der Figur 4;
- Figur 5b: eine zweite Variante einer vergrößerten Darstellung des mit Vb bezeichneten Teilbereichs aus der Figur 4;
- Figur 5c: eine dritte Variante einer vergrößerten Darstellung des mit Vb bezeichneten Teilbereichs aus der Figur 4;
- Figur 6: eine schematische Darstellung von Verfahren zur Herstellung von Halbleiterwafer-Solarzellen unter Einsatz eines erfindungsgemäßen Carriersystems und
- Figur 7: eine schematische Darstellung für die Herstellung eines Solarmoduls unter Verwendung von Halbleiter-Solarzellen, die unter Einsatz eines erfindungsgemäßen Carriersystems hergestellt wurden.

In den Figuren 1a und 1b bzw. 2a und 2b sind zwei aus dem Stand der Technik bekannte Carriersysteme dargestellt. Diese wurden im Rahmen der Beschreibungseinleitung zum Stand der Technik beschrieben.

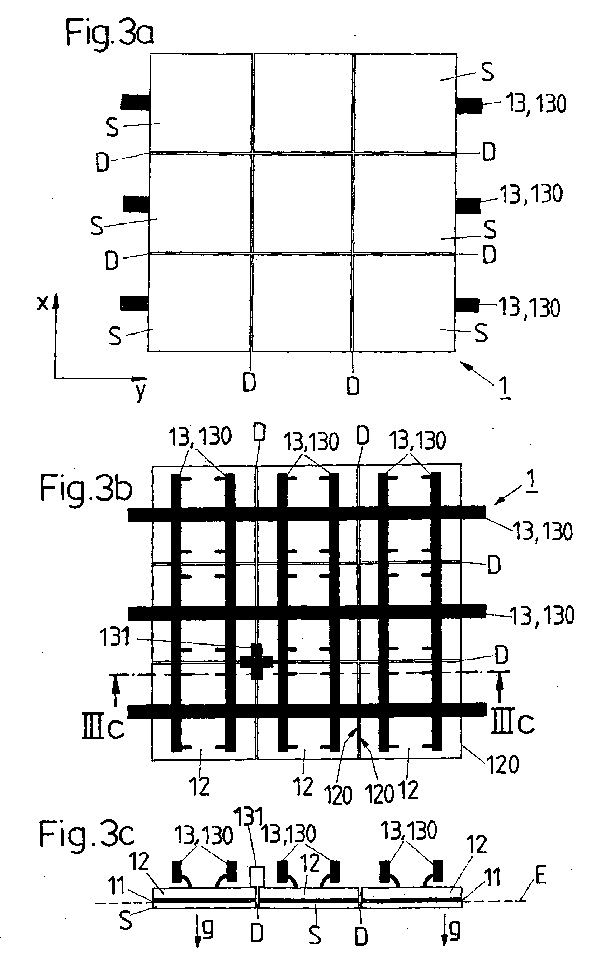

Figur 3a zeigt eine schematische Darstellung einer bevorzugten Ausführungsform eines erfindungsgemäßen Carriersystems 1 zusammen mit neun am Carriersystem 1 fixierten Substraten S in einer Ansicht der Unterseite gemäß der Ansichtrichtung der Figuren 1 a und 2a. Die neun Substrate mit gleichen Abmessungen sind als flächige quadratische Halbleiterwafer S ausgebildet, die in einem 3x3 Raster entlang zweier mit X und Y bezeichneter Raumrichtungen periodisch angeordnet sind. Die Halbleiterwafer S sind durch schmale, spaltförmige Angrenzbereiche D voneinander beabstandet.

Figur 3b zeigt eine schematische Ansicht der Oberseite des in Figur 3a gezeigten Carriersystems 1. Neun gleiche Trägerelemente 12 mit quadratischer Grundfläche sind in einem gleichmäßigen 3x3 Raster ausgerichtet, wobei die Trägerelemente 12 mit ihren Begrenzungskanten 120 voneinander durch einen Spalt beabstandet sind, dessen Spaltmaße (Breite/Länge) im Wesentlichen den entsprechenden Maßen des Angrenzbereich D der in Figur 3a gezeigten Halbleiterwafer S entspricht. Dies liegt darin begründet, dass die Grundfläche der Trägerelemente 12 jeweils den Kantenmaßen der quadratischen Halbleiterwafer S entspricht. Dieser Spalt lässt sich nach oben hin mit einer Auffangvorrichtung 131 abdecken. Im einfachsten Fall handelt es sich dabei um einfache Blechmasken, die über den Angrenzbereichen D fixiert werden. Die Blechmasken sind dabei derart ausgebildet, dass gasförmiges Depositionsmaterial, das durch den schmalen Angrenzbereich D nach oben steigt in der Auffangvorrichtung aufgehalten wird und nicht weiter nach oben steigen kann. In der Darstellung der Figur 3b ist aus Gründen der Übersichtlichkeit nur ein geringer Bereich des Spalts im Angrenzbereich D mittels der Auffangvorrichtung 131 abgedeckt. Ebenso ist denkbar, dass eine Vielzahl von Auffangvorrichtungen 131 alle Angrenzbereiche D abdecken.

Das Carriersystem 1 weist eine Haltevorrichtung 13 mit Koppelmitteln 130 auf. Die Haltevorrichtung dient zum einen dazu, das Carriersystem 1 in einer Prozessanlage derart zu positionieren, dass die Schwerkraft g auf die Halbleiterwafer S nicht ausschließlich in Richtung der Trägerelemente 12 wirkt. Zum anderen dienen die Koppelmittel 130 dazu, die einzelnen Trägerelemente 12 mechanisch miteinander zum Carriersystem 1 zu verbinden. Dazu weist jedes Trägerelement 12 eine Mehrzahl von Haken auf, die sich in rasterförmig angeordnete Halteschienen einhaken lassen.

Dies ist in Figur 3c, die eine nicht maßstabsgerechte, schematische Schnittansicht des Carriersystems aus Figur 3b entlang der Linie IIIc-IIIc zeigt, erkennbar. Es wird betont, dass die Schichtdicke der Halbleiterwafer S der besseren Erkennbarkeit wegen übertrieben stark dargestellt wurde. Gleiches gilt für die zwischen den Trägerelementen 12 und den Halbleiterwafern S angeordneten Fixiermittel 11. Die Halbleiterwafer S haben üblicherweise eine Stärke von 150 bis 200µm. Die Fixiermittel 11 weisen in der Variante der Adhäsionsfolie typische Ausmaße im Bereich von 10 bis 50µm auf. Wenn die Fixiermittel 11 zusätzlich oder alternativ eine Flüssigkeit aufweisen, weist der Flüssigkeitsfilm üblicherweise Ausmaße im Bereich von 5 bis 20µm auf.

In Figur 3c ist weiterhin erkennbar, dass die Trägerelemente 12 derart angeordnet sind, dass die plan ausgebildeten und auf den Trägerelementen 12 angeordneten Fixiermittel 11 in einer gemeinsamen Kontaktebene E zu liegen kommen. Auf diese Weise ist gewährleistet, dass die am Carriersystem 1 fixierten Halbleiterwafer S mit ihren zu prozessierenden Substratoberflächen eine gemeinsame Ebene bilden, die nur durch die schmalen spaltförmigen Angrenzbereiche D unterbrochen ist. In der Schnittdarstellung der Figur 3c ist ebenfalls die Auffangvorrichtung 131 erkennbar. Diese weist - wie hier beispielhaft gezeigt - einen rechteckigen Querschnitt auf. Eine Vielzahl anderer Querschnitte ist ebenfalls denkbar, um die Funktion zu erfüllen, die Haltevorrichtung 13 vor Depositionsmaterial zu schützen, das durch die Angrenzbereiche D aufsteigt.

An dieser Stelle sei betont, dass hier nur eine einzige bevorzugte Ausführungsform des erfindungsgemäßen Carriersystems 1 im Detail dargestellt ist. Eine Vielzahl anderer Varianten ist denkbar, insbesondere können die Kontaktbereiche 10 im Vergleich zur zu prozessierenden Oberfläche des Substrats S deutlich kleiner ausfallen. Die Anordnung der Fixiermittel 11 mit den entsprechenden Kontaktbereichen 10 und der Haltevorrichtung 13 des Carriersystems 1 im Wesentlichen außerhalb der Angrenzbereiche D ermöglicht die erwünschte Minimierung des Angrenzbereichs benachbarter Substraten S.

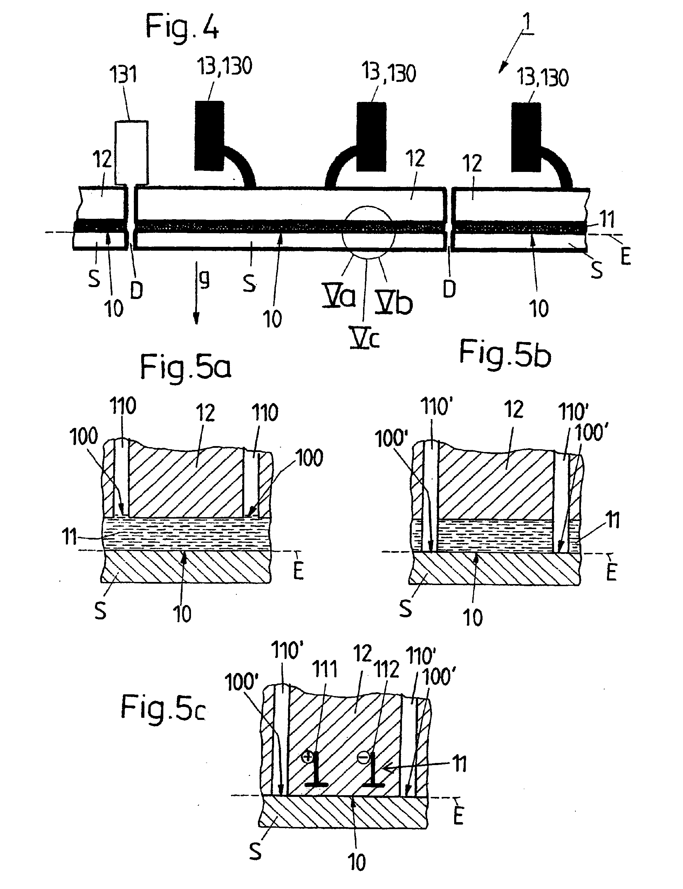

In Figur 4, die eine vergrößerte Darstellung eines Ausschnitts der Schnittdarstellung aus Figur 3c zeigt, ist erkennbar, dass die Fixiermittel 11, die Trägerelemente 12 und die Haltevorrichtung 13 ausschließlich auf der den Halbleiterwafern S abgewandten Seite der Kontaktebene E angeordnet sind. Auf diese Weise ist gewährleistet, dass die Angrenzbereiche D zwischen benachbarten Halbleiterwafern S minimiert werden können. Als Angrenzbereich wird der Raumbereich verstanden, der bei einer fiktiven Verlängerung eines ersten Substrates zu einem benachbarten zweiten Substrat durchgriffen würde. Im dargestellten Fall handelt es sich somit um einen quaderförmigen Bereich mit Kantenlängen des Halbleiterwafers S, einer Breite des Abstands zwischen zwei benachbarten Halbleiterwafern S und einer Höhe, die der vorangehend beschriebenen Stärke des Halbleiterwafers S entspricht.

Da die zum Einsatz kommenden, dünnen Halbleiterwafer S sehr bruchempfindlich sind, ist es vorteilhaft, einen Angrenzbereich D mit einer Spaltbreite von in etwa einem Millimeter einzuhalten, um einen Kontakt der benachbarten Kanten zu vermeiden.

Figur 5a zeigt eine vergrößerte Darstellung des mit Va bezeichneten Teilbereichs aus der Figur 4. Dies ist eine Variante des Carriersystems 1, bei der die Fixiermittel als flüssiges Klebemittel 11 ausgebildet sind. Dazu eignen sich insbesondere ionische Flüssigkeiten, da diese bei einem niedrigen Dampfdruck eine ausreichend hohe Wärmeleitfähigkeit aufweisen. Im Hinblick auf die verschiedenen Möglichkeiten der thermischen Kopplung eines Substrats mit einer Wärmesenke, hier in Form des Trägerelementes 12, wird hiermit auf die deutsche Patentanmeldung DE 10 2007 006 455 verwiesen.

Das Trägerelement 12 weist eine Mehrzahl von im Wesentlichen senkrecht zur Kontaktebene E angeordneten Kanälen 110 auf, die in Öffnungen 100 einmünden, die an das flüssige Fixiermittel 11 beispielsweise in Form ionischer Flüssigkeit angrenzen. Diese Öffnungen 100 in der als Kontaktbereich 10 wirkenden Oberfläche der Fixiermittel 11 dienen zusammen mit den sich daran anschließenden Kanälen 110 dazu, eventuelle Gaseinschlüsse zwischen der ionischen Flüssigkeit 11, dem Substrat S und der Oberfläche des Trägerelements 12 abzuführen, wenn das Carriersystem 1 mit dem daran fixierten Substrat S Vakuumbedingungen ausgesetzt wird. Dazu ist es erforderlich, eine hinreichende Dichte von Öffnungen 100 in den Trägerelementen 12 des Carriersystems 1 vorzusehen. Eine Variante sieht vor, dass pro Quadratmillimeter eine Öffnung 100 mit einem Kanaldurchmesser von circa 100 µm vorgesehen ist. Es ist selbstverständlich, dass die Dichte und die Geometrie der Öffnungen 100 samt der daran anschließenden Kanäle 110 an die jeweiligen Einsatzbedingungen angepasst werden können und müssen. Diese Kanäle 110 gewährleisten, dass möglicherweise in der ionischen Flüssigkeit befindliche Gaseinschlüsse durch die Kanäle 110 entweichen können, wenn in einer Prozessanlage Vakuumbedingungen eingestellt werden. Ansonsten besteht die Gefahr, dass die beim Einstellen der Vakuumbedingungen expandierenden Gaseinschlüsse zu einem Ablösen des Substrates S vom Trägerelement 12 des Carriersystems 1 führen.

Eine zweite Variante für die Ausbildung der Fixiermittel 11 zeigt Figur 5b. Dies entspricht wieder einer vergrößerten Darstellung des mit Vb bezeichneten Teilbereichs aus der Figur 4. Anders als bei der in Figur 5a gezeigten Variante erstrecken sich Saugkanäle 110' durch die Fixiermittel 11 hindurch, um in Saugöffnungen 110' benachbart zum Halbleiterwafer S zu enden. In diesem Fall sind die Fixiermittel 11 als Adhäsionsfolie ausgeführt, die mit einer Vielzahl von Saugkanälen 100' mit Saugöffnungen 110' perforiert ist.

Eine dritte Variante für die Ausbildung der Fixiermittel 11 zeigt Figur 5c. Diese Figur entspricht wieder einer Vergrößerung des in Figur 4 dargestellten Teilbereichs. Die Fixiermittel 11 des Trägerelements 12 weisen bei dieser Variante eine im Trägerelement 12 vorgesehene elektrostatisch wirkende Fixiervorrichtung auf. Diese elektrostatische Fixiervorrichtung ist hier rein schematisch in Form zweier gegenpoliger Elektroden 111,112 dargestellt. Im Hinblick auf nähere Details wird auf die im Zusammenhang mit der Erläuterung der Patentansprüche gemachten Ausführungen verwiesen. Entgegen der hier gezeigten Darstellung kann zwischen Trägerelement 12 und dem zu fixierenden Substrat S eine Polymerfolie vorgesehen sein.

Die Saugkanäle 110' lassen sich zum Ansaugen eines Halbleiterwafers S verwenden, um bei den ersten beiden Varianten einen innigen Kontakt zwischen Halbleiterwafer S und dem Fixiermittel 11 herzustellen. Dabei bildet die Grenzfläche des Fixiermittels 11 den Kontaktbereich zum Fixieren des Substrates. Ebenso lässt sich der Halbleiterwafer S durch eine Druckerhöhung in den Saugkanälen 110' auf schonende Weise von den Fixiermitteln 11 ablösen.

Bei der dritten Variante gemäß Figur 5c dienen die Saugkanäle 110' zum Ansaugen des Halbleiterwafers S an das Trägerelement 12 des Carriersystems 1. Bei dieser Variante wirkt die ebene Oberfläche des Trägerelements 12 als Kontaktbereich 10 zum Fixieren des Substrates S.

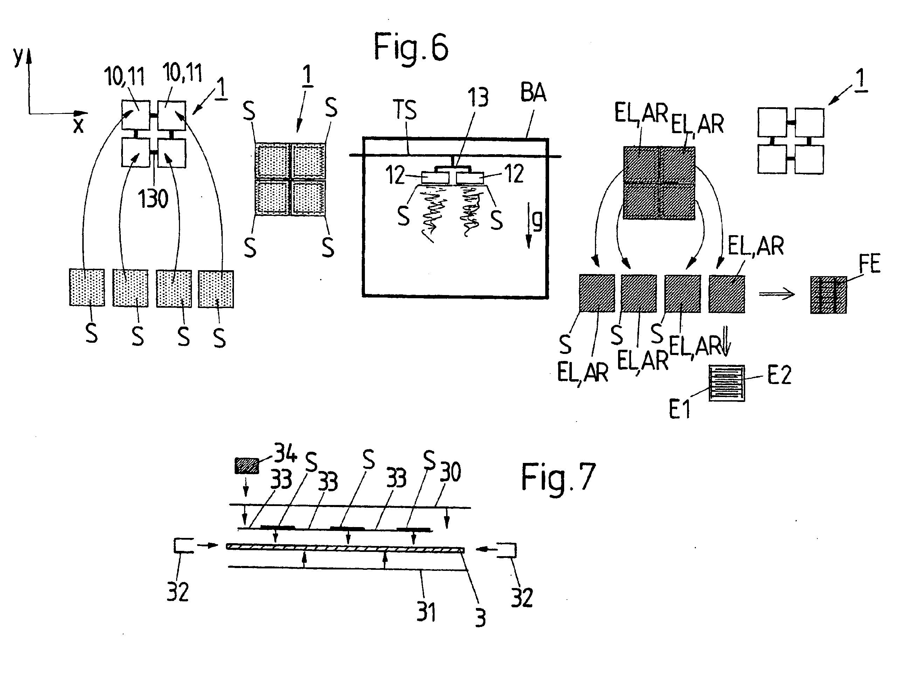

Figur 6 zeigt eine schematische Darstellung eines Verfahrens zur Herstellung von Halbleiterwafer-Solarzellen unter Einsatz eines erfindungsgemäßen Carriersystems 1. In einem ersten Verfahrensschritt wird ein Carriersystem 1 mit vier quadratisch gleichmäßig angeordneten und über Koppelelemente 130 miteinander verbundenen Trägerelementen 12 bereitgestellt. Jedes Trägerelement 12 zeigt an seiner Oberfläche einen Kontaktbereich 10 mit Fixiermitteln 11. In einem zweiten Verfahrensschritt werden vier Halbleiterwafer S über die Fixiermittel 11 am Carriersystem 1 fixiert. Anschließend wird das Carriersystem 1 mit den daran fixierten Substraten S in eine Prozessanlage BA eingeführt. Schematisch ist dargestellt wie das Carriersystem 1 mittels einer Haltevorrichtung 13 mit einem die Prozessanlage BA durchlaufenden Transportsystem TS gekoppelt ist. In der Prozessanlage BA wird auf den zu prozessierenden Oberflächen der Halbleiterwafer S beispielsweise eine elektrisch leitfähige Schicht EL oder eine Antireflexionsschicht AR abgeschieden. Nach dem Durchlaufen des Carriersystems 1 werden die prozessierten Halbleiterwafer S vom Carriersystem 1 gelöst und das Carriersystem 1 steht zum Prozessieren weiterer Halbleiterwafer S in der Prozessanlage BA zur Verfügung.

Vor dem Abscheiden einer elektrisch leitfähigen Schicht EL wurden die Halbleiterwafer S mit mindestens einem p-n-Übergang zur Bildung einer Solarzelle bereitgestellt. Dabei handelt es sich beispielsweise um einen großflächigen p-n-Übergang, der sich über die gesamte Oberfläche der einen Seite der Halbleiterwafer S erstreckt. Zusätzlich ist diese Seite der Wafer S bereits mit einer Antireflexionsschicht AR und einer gitterähnlichen Frontelektrode FE versehen. In der Prozessanlage BA wird dann die andere Seite der Halbleiterwafer S mit einer elektrisch leitfähigen Schicht EL versehen. Eine weitere Variante eines Halbleiterwafers mit großflächigem p-n-Übergang besteht darin, dass sich die p- oder die n-Schicht über sowohl über die eine Seite (Vorderseite) als auch über die andere Seite (Rückseite) des Wafers erstreckt und durch Öffnungen in der Waferfläche, die dotierte Schicht der Vorderseite mit der der Rückseite in Verbindung steht.

Ebenso ist denkbar, dass die Halbleiterwafer S mit einer Mehrzahl auf einer Oberfläche angeordneter p-n-Übergänge bereitgestellt werden. Die auf dieser Oberfläche abgeschiedene elektrisch leitfähige Schicht EL wird noch einem nachgeordneten Strukturierungsschritt unterzogen, derart dass auf der Substratoberfläche zwei kammförmig ineinander greifende Elektrodenstrukturen E1 und E2 gebildet werden.

Als weitere Verfahrensvariante ist denkbar, dass in der Prozessanlage BA eine Antireflexionsschicht AR abgeschieden wird und in einem anschließenden Druckprozess, beispielsweise durch ein Siebdruckverfahren, auf die Antireflexionsschicht AR eine gitterförmige Frontelektrode FE aufgebracht wird. Diese in Form einer Metallpaste aufgebrachte Frontelektrode FE wird in einem anschließenden thermischen Verfahrensschritt in die Oberfläche des Halbleiterwafers S eingebrannt.

Mit dem erfindungsgemäßen Verfahren werden unter Einsatz eines erfindungsgemäßen Carriersystems 1 eine Antireflexionsschicht AR oder eine elektrisch leitfähige Schicht EL auf einem Halbleiterwafer mit p-n-Struktur abgeschieden, um eine Halbleiterwafer-Solarzelle herzustellen. Die elektrisch leitfähige Schicht EL oder die Antireflexionsschicht können jedoch auch mit Verfahren und Vorrichtungen hergestellt werden, die aus dem Stand der Technik bekannt sind. Hier ist also eine Vielzahl von Kombinationsmöglichkeiten denkbar.

Figur 7 zeigt eine schematische Darstellung für die Herstellung eines Solarmoduls unter Verwendung von Halbleiter-Solarzellen, die unter Einsatz eines erfindungsgemäßen Carriersystems hergestellt wurden.

Dazu werden die Solarzellen S mittels elektrischer Leiter 33 in Serie miteinander verschaltet und auf einem Trägerelement 3 aufgebracht und fixiert. Anschließend wird die Vorder- und die Rückseite dieser flächigen Struktur gegenüber Umwelteinflüssen verkapselt. Die flächige Struktur wird beispielsweise mittels Folien 30 oder Glasscheiben 31 abgedeckt. Das auf diese Weise gebildete Laminat kann entlang seiner Außenkanten mit Rahmenelementen 32, beispielsweise in Form U-förmiger Profile, eingefasst und mittels eines Klebstoffes im Rahmenelement 32 fixiert werden. Zusätzlich erfolgt noch das Anbringen einer elektrischen Kontakteinrichtung 34, um den Anschluss des verkapselten Moduls an ein Stromnetz zu ermöglichen.

## Patentansprüche

1. Carriersystem (1) zum Fixieren einer Mehrzahl zu prozessierender Substrate (S), umfassend
• mindestens zwei Kontaktbereiche (10) mit Fixiermitteln (11) zum Fixieren eines Substrates (S) an einem zugeordneten Kontaktbereich (10), wobei sich zwischen zwei benachbarten Substraten (S) Angrenzbereiche (D) ausbilden,
• eine Haltevorrichtung (13), mittels der sich das Carriersystem bei einem Prozessieren der Substrate (S) in einer Prozessanlage (BA) räumlich derart anordnen lässt, dass die auf die Substrate (S) wirkende Schwerkraft (g) eine Kraftkomponente aufweist, die von dem jeweils zugeordneten Kontaktbereich (10) weg weist,
wobei die Kontaktbereiche (10) in Form ebener quadratischer oder rechteckiger Flächen ausgebildet sind, dass sich durch die Fixiermittel (11) eine auf das Substrat (S) in Richtung des Kontaktbereiches (10) wirkende Haftkraft ausüben lässt und dass die Haltevorrichtung (13) und die Fixiermittel (11) im Wesentlichen außerhalb der Angrenzbereiche (D) angeordnet sind und wobei jeder Kontaktbereich (10) auf einem zugeordneten Trägerelement (12) vorgesehen ist
**dadurch gekennzeichnet,**
**dass** das Trägerelement (12) zusammen mit dem Fixiermittel (11) als Wärmesenke für ein am Kontaktbereich (10) fixiertes Substrat (S) ausgebildet ist.

2. Carriersystem (1) gemäß Anspruch 1 , **dadurch gekennzeichnet, dass** das Trägerelement (12) aus der Blickrichtung eines zu fixierenden Substrates (S) im Wesentlichen die gleiche oder eine kleinere Ausdehnung aufweist wie ein zu fixierendes Substrat (S).

3. Carriersystem (1) gemäß einem der Ansprüche 1 oder 2, **dadurch gekennzeichnet, dass** jedes Trägerelement (12) als separates Bauelement ausgebildet ist und die Haltevorrichtung (13) an jedem Trägerelement (12) Koppelmittel (130) zur mechanischen Kopplung der einzelnen Trägerelemente (12) aufweist.

4. Carriersystem (1) gemäß einem der Ansprüche 1 bis 3, **dadurch gekennzeichnet, dass** die Trägerelemente (12) geradlinige Begrenzungskanten (120) derart aufweisen und die Trägerelemente (12) mit den Begrenzungskanten (120) zueinander benachbart derart angeordnet sind, dass sich zwischen den Begrenzungskanten (120) ein Spaltmaß von weniger als 5mm, bevorzugt von weniger als 2mm ausbildet.

5. Carriersystem (1) gemäß Anspruch 4, **dadurch gekennzeichnet, dass** auf der von den Substraten (S) abgewandten Seite der Trägerelemente (12) entlang der Begrenzungskanten (120) Auffangeinrichtungen (131) angeordnet sind, die gasförmiges Depositionsmaterial aufnehmen, das zwischen den Begrenzungskanten aufsteigt, derart, dass die Auffangeinrichtung (131) das gasförmige Depositionsmaterial von der Halteeinrichtung (13) mit den Koppelmitteln (130) fern hält.

6. Carriersystem (1) gemäß einem der vorangehenden Ansprüche, **dadurch gekennzeichnet, dass** die Fixiermittel (11) eine auf zu fixierende Substrate (S) elektrostatisch wirkende Fixiervorrichtung aufweisen.

7. Carriersystem (1) gemäß einem der vorangehenden Ansprüche, **dadurch gekennzeichnet, dass** in den Kontaktbereichen (10) eine Vielzahl von Öffnungen (100) mit sich daran anschließenden Kanälen (110) derart vorgesehen sind, dass bei einem Evakuieren der Umgebung des Carriersystems (1) Gaseinschlüsse zwischen zu fixierenden Substraten (S) und den Kontaktbereichen (10) über die Kanäle (110) ableitbar sind.

8. Carriersystem (1) gemäß einem der vorangehenden Ansprüche, **dadurch gekennzeichnet, dass** in den Kontaktbereichen (10) mindestens eine Saugöffnung (100') mit daran anschließendem Saugkanal (110') derart vorgesehen ist, dass sich ein zu fixierendes Substrat (S), das mit dem Kontaktbereich (10) in Kontakt steht, durch das Anlegen eines Unterdruckes im Saugkanal (110') auf den Kontaktbereich (10) aufpressen lässt.

9. Verfahren zum Prozessieren einer Mehrzahl von Substraten (S) in einer Prozessantage (BA) umfassend die folgenden Verfahrensschritte:
- Bereitstellen einer Mehrzahl flächiger Substrate (S) mit quadratischer oder rechteckiger Substratoberfläche;
- Bereitstellen eines Carriersystems (1) mit den Merkmalen gemäß einem der Ansprüche 1 bis 8;
- Fixieren der Substrate (S) auf den zugeordneten Kontaktbereichen (10) des Carriersystems;
- Bereitstellen des Carriersystems (1) einschließlich fixierter Substrate (S) in der Prozessanlage (BA), wobei das Carriersystem (1) über die Haltevorrichtung (13) derart orientiert ist, dass die auf die Substrate (S) wirkende Schwerkraft (g) eine Kraftkomponente aufweist, die von dem jeweils zugeordneten Kontaktbereich (10) weg weist;
- Prozessieren der Substrate (S) in der Prozessanlage (BA) und
- Lösen der Substrate (S) von den zugeordneten Kontaktbereichen (10),
**dadurch gekennzeichnet,**
**dass** die Substrate (S) als Halbleiterwafer mit einem p-n-Übergang für eine Solarzelle bereitgestellt werden und der Verfahrensschritt des Prozessierens der Substrate (S)
- als Beschichtung einer Seite jedes Substrates mit einer elektrisch leitfähigen Schicht (EL), bevorzugt einer Aluminiumschicht, ausgebildet ist
oder
- als Beschichtung einer Seite jedes Substrates (S) mit einer SiN-Dünnschicht (AR) in einer als Sputter- oder PECVD-Antage ausgebildeten Prozessanlage (BA) durchgeführt wird.

10. Verfahren gemäß Anspruch 9, **dadurch gekennzeichnet, dass** die Halbleiterwafer (S) derart fixiert werden, dass die Angrenzbereiche (D) zwischen den Substraten (S) auf eine Breite von kleiner 5 mm, bevorzugt kleiner 1 mm minimiert werden.

11. Verfahren gemäß Anspruch 10, **dadurch gekennzeichnet, dass** der Verfahrensschritt des Prozessierens der Halbleiterwafer (S) als ein Prozess oder eine Kombination von Prozessen aus der Vakuumtechnologie ausgebildet ist und das Prozessieren der Halbleiterwafer (S) im Vakuum bei einem Druck von unter 500 Pa, bevorzugt von unter 1 Pa und besonders bevorzugt von unter 0,01 Pa durchgeführt wird.

12. Verfahren gemäß einem der Ansprüche 9 bis 11, **dadurch gekennzeichnet, dass** die Halbteiterwafer (S) mit auf einer ersten Seite der Halbleiterwafer angeordneten ersten Elektrodenstrukturen bereitgestellt werden, wobei die elektrisch leitfähige Schicht (EL) als zweite Elektrodenstruktur auf der zweiten Seite des Halbleiterwafers abgeschieden wird, um eine Halbleiterwafer-Solarzelle zu bilden.

13. Verfahren gemäß einem der Ansprüche 9 bis 11, **dadurch gekennzeichnet, dass** die elektrisch leitfähige Schicht (EL) mittels eines Strukturierungsschrittes in eine erste Elektrodenstruktur (E1) und in eine zweite Elektrodenstruktur (E2) strukturiert wird, um eine Halbleiterwafer-Solarzelle zu bilden.

14. Verfahren gemäß Anspruch 9, **dadurch gekennzeichnet, dass** auf die SiN-Dünnschicht (AR) mittels eines Druckschrittes eine Frontelektrodenstruktur (FE) aufgebracht wird, die anschließend mittels eines thermischen Verfahrensschrittes in die Oberfläche eingebrannt wird, um eine Halbleiterwafer-Solarzelle zu bilden.

15. Verfahren gemäß einem der Ansprüche 12 bis 14, **dadurch gekennzeichnet, dass** eine Mehrzahl von Halbleiterwafer-Solarzellen (S) elektrisch miteinander gekoppelt, auf einem Trägerelement (3) fixiert und gegenüber Umwelteinflüssen mittels Glasscheiben und/oder Folien (30, 31) und/oder Rahmenelementen (32) verkapselt werden, derart, dass aus der Mehrzahl von Halbleiterwafer-Solarzellen (S) ein Solarmodul gebildet wird.

## Claims

1. A carrier system (1) for fixing a plurality of substrates (S) to be processed, comprising
• at least two contact regions (10) with fixing means (11) for fixing a substrate (S) to an associated contact region (10), wherein abutting regions (D) form between two adjacent substrates (S),
• a holding device (13) by means of which the carrier system can be spatially arranged during processing the substrates (S) in a processing system (BA) in such a manner that the gravity (g) acting on the substrates (S) has a force component which points away from the respectively associated contact region (10),
wherein the contact regions (10) are configured in the form of flat square or rectangular surfaces, an adhesive force acting on the substrates (S) in the direction of the contact region (10) can be applied by the fixing means (11), and the holding device (13) and the fixing means (11) are arranged substantially outside of the abutting regions (D), and wherein each contact region (10) is provided on an associated carrier element (12),
**characterized in**
**that** the carrier element (12) together with the fixing means (11) is configured as heat sink for a substrate (S) fixed on the contact region (10).

2. The carrier system (1) according to claim 1, **characterized in that** from the viewing direction of a substrate (S) to be fixed, the carrier element (12) has substantially the same or a smaller extension than a substrate (S) to be fixed.

3. The carrier system (1) according to claim 1 or claim 2, **characterized in that** each carrier element (12) is configured as separate component and the holding device (13) has coupling means (130) on each carrier element (12) for mechanically coupling the individual carrier elements (12).

4. The carrier system (1) according to any one of the claims 1 to 3, **characterized in that** the carrier elements (12) have straight boundary edges (120) in such a manner and the carrier elements (12) and boundary edges (120) are arranged adjacent to each other in such a manner that between the boundary edges (120) a gap dimension of less than 5 mm, preferred of less than 2 mm forms.

5. The carrier system (1) according to claim 4, **characterized in that** on the carrier elements' (12) side facing away from the substrates (S), collecting devices (131) are arranged along the boundary edges (120) which collecting devices receive gaseous deposition material that rises between the boundary edges such that the collecting device (131) keeps the gaseous deposition material away from the holding device (13) with the coupling means (130).

6. The carrier system (1) according to any one of the preceding claims, **characterized in that** the fixing means (11) have a fixing device which acts electrostatically on substrates (S) to be fixed.

7. The carrier system (1) according to any one of the preceding claims, **characterized in that** in the contact regions (10), a plurality of openings (100) with channels (110) connected thereto is provided in such a manner that when evacuating the environment of the carrier system (1), gas inclusions between the substrates (S) to be fixed and the contact regions (10) can be discharged via the channels (110).

8. The carrier system (1) according to any one of the preceding claims, **characterized in that** in the contact regions (10) at least one suction opening (100') with a suction channel (110') connected thereto is provided in such a manner that a substrate (S) to be fixed which is in contact with the contact region (10) can be pressed onto the contact region (10) by applying a negative pressure in the suction channel (110').

9. A method for processing a plurality of substrates (S) in a processing system (BA), comprising the following methods steps:
- providing a plurality of flat substrates (S) with square or rectangular substrate surface;
- providing a carrier system (1) with the features according to any one of the claims 1 to 8;
- fixing the substrates (S) on the associated contact regions (10) of the carrier system;
- providing the carrier system (1) including fixed substrates (S) in the processing system (BA), wherein the carrier system (1) is oriented via the holding device (13) in such a manner that the gravity (g) acting on the substrates (S) has a component which points away from the respectively associated contact region (10);
- processing the substrates (S) in the processing system (BA), and
- detaching the substrates (S) from the associated contact regions (10),
**characterized in**
**that** the substrates (S) are provided as semi-conductor wafers with a p-n-junction for a solar cell and the method step of processing the substrates (S)
- is configured as coating one side of each substrate with an electrically conductive layer (EL), preferred with an aluminum layer,
or
- is carried out as coating one side of each substrate (S) with a SiN thin-layer (AR) in a process system (BA) configured as sputtering or PECDV system.

10. The method according to claim 9, **characterized in that** the semi-conductor wafers (S) are fixed in such a manner that the abutting regions (D) between the substrates (S) are minimized to a width of smaller than 5 mm, preferred smaller than 1 mm.

11. The method according to claim 10, **characterized in that** the method of processing the semi-conductor wafer (S) is configured as a process or a combination of processes from the vacuum technology and processing the semi-conductor wafers (S) is carried out in a vacuum at a pressure below 500 Pa, preferred below 1 Pa and particularly preferred below 0.01 Pa.

12. The method according to any one of the claims 9 to 11, **characterized in that** the semi-conductor wafers (S) are provided with first electrode structures arranged on a first side of the semi-conductor wafers, wherein the electrically conductive layer (EL) is deposited as second electrode structure on the second side of the semi-conductor wafer so as to form a semi-conductor wafer solar cell.

13. The method according to any one of the claims 9 to 11, **characterized in that** the electrically conductive layer (EL) is structured by means of a structuring step into a first electrode structure (E1) and into a second electrode structure (E2) so as to form a semi-conductor wafer solar cell.

14. The method according to claim 9, **characterized in that** a front electrode structure (FE) is applied onto the SiN thin-layer (AR) by means of a printing step, which front electrode structure is subsequently burnt into the surface by means of a thermal method step so as to form a semi-conductor wafer solar cell.

15. The method according to any one of the claims 12 to 14, **characterized in that** a plurality of semi-conductor wafer solar cells (S) are electrically coupled to each other, fixed on a carrier element (3), and encapsulated with respect to environmental influences by means of glass panes and/or foils (30, 31) and/or frame elements (32) in such a manner that from the plurality of semi-conductor wafer solar cells (S), one solar module is formed.

## Revendications

1. Système porteur (1) pour la fixation d'une pluralité de substrats (S) à traiter, comprenant
• au moins deux zones de contact (10) avec des moyens de fixation (11) pour fixer un substrat (S) sur une zone de contact (10) affectée, dans lequel des zones contiguës (D) se forment entre deux substrats (S) voisins,
• un dispositif de retenue (13), au moyen duquel le système porteur peut être disposé spatialement lors d'un traitement des substrats (S) dans une installation de traitement (BA) de telle sorte que la force de gravité (g) agissant sur les substrats (S) présente un composant de force, qui se détourne de la zone de contact (10) respectivement affectée,
dans lequel les zones de contact (10) sont réalisées sous forme de surfaces carrées ou rectangulaires plates, en ce que une force d'adhérence agissant sur le substrat (S) dans la direction de la zone de contact (10) peut être exercée par l'intermédiaire du moyen de fixation (11) et en ce que le dispositif de retenue (13) et le moyen de fixation (11) sont disposés essentiellement à l'extérieur des zones contiguës (D) et dans lequel chaque zone de contact (10) est prévue sur un élément porteur (12) affecté,
**caractérisé en ce que**
l'élément porteur (12) est réalisé conjointement au moyen de fixation (11) comme un puits thermique d'un substrat (S) fixé sur la zone de contact (10).

2. Système porteur (1) selon la revendication 1, **caractérisé en ce que** l'élément porteur (12) présente dans l'axe de vision d'un substrat (S) à fixer essentiellement la même expansion ou une expansion plus petite qu'un substrat (S) à fixer.

3. Système porteur (1) selon une des revendications 1 ou 2, **caractérisé en ce que** chaque élément porteur (12) est réalisé comme un composant séparé et le dispositif de retenue (13) présente sur chaque élément porteur (12) un moyen de couplage (130) pour le couplage mécanique des éléments porteurs (12) individuels.

4. Système porteur (1) selon une des revendications 1 à 3, **caractérisé en ce que** les éléments porteurs (12) présentent des arêtes de délimitation (120) en ligne droite et les éléments porteurs (12) sont disposés avec les arêtes de délimitation (120) à côté les uns des autres de telle sorte que ente les arêtes de délimitation (120) un interstice de moins de 5mm, de préférence de moins de 2mm soit formé.

5. Système porteur (1) selon la revendication 4, **caractérisé en ce que** sur le côté qui se détourne des substrats (S) des éléments porteurs (12) le long des arêtes de délimitation (120), des dispositifs de captage (131) sont disposés, qui renferment le matériau de dépôt gazeux, qui s'élève entre les arêtes de délimitation, de telle sorte que le dispositif de captage (131) tienne à distance du dispositif de retenue (13) le matériau de dépôt gazeux avec les moyens de couplage (130).

6. Système porteur (1) selon une des revendications précédentes, **caractérisé en ce que** le moyen de fixation (11) présente un dispositif de fixation exerçant une action électrostatique sur les substrats (S) à fixer.

7. Système porteur (1) selon une des revendications précédentes, **caractérisé en ce que** dans les zones de contact (10) une pluralité d'ouvertures (100) avec des canaux (110) s'y rattachant sont prévues de telle sorte que lors d'une évacuation de l'environnement du système porteur (1), des inclusions de gaz entre des substrats (S) à fixer et les zones de contact (10) puissent être évacuées par l'intermédiaire des canaux (110).

8. Système porteur (1) selon une des revendications précédentes, **caractérisé en ce que** dans les zones de contact (10) au moins une ouverture d'aspiration (100') avec un canal d'aspiration (110') s'y rattachant est prévue de telle sorte qu'un substrat (S) à fixer, qui est en contact avec la zone de contact (10), puisse être compressé par l'application d'une dépression dans le canal d'aspiration (110') sur la zone de contact (10).

9. Procédé de traitement d'une pluralité de substrats (S) dans une installation de traitement (BA) comprenant les étapes de procédé suivantes :
- fourniture d'une pluralité de substrats (S) plats avec une surface de substrat carrée ou rectangulaire;
- fourniture d'un système porteur (1) présentant les caractéristiques d'une des revendications 1 à 8 ;
- fixation des substrats (S) sur les zones de contact (10) affectées du système porteur ;
- fourniture du système porteur (1) y compris les substrats (S) fixés dans l'installation de traitement (BA), dans lequel le système porteur (1) est orienté par l'intermédiaire du dispositif de retenue (13) de telle sorte que la force de gravité (g) agissant sur les substrats (S) présente un composant de force, qui se détourne de la zone de contact (10) respectivement affectées ;
- traitement des substrats (S) dans l'installation de traitement (BA) et
- séparation des substrats (S) des zones de contact (10) affectées,
**caractérisé en ce que**
les substrats (S) sont fournis comme des tranches de semi-conducteur avec une transition p-n pour une cellule solaire et l'étape de procédé du traitement des substrats (S)
- est réalisée comme un revêtement de chaque côté de chaque substrat avec une couche (EL) électriquement conductrice, de préférence une couche d'aluminium, ou
- est effectuée comme un revêtement d'un côté de chaque substrat (S) avec une couche mince SiN (AR) dans une installation de traitement (BA) réalisée comme une installation de dépôt par pulvérisation cathodique ou une installation de dépôt chimique en phase vapeur assisté par plasma.

10. Procédé selon la revendication 9, **caractérisé en ce que** les tranches de semi-conducteur (S) sont fixées de telle sorte que les zones contiguës (D) entre les substrats (S) soient minimisées sur une largeur inférieure à 5mm, de préférence inférieure à 1mm.

11. Procédé selon la revendication 10, **caractérisé en ce que** l'étape de procédé du traitement de la tranche de semi-conducteur (S) est réalisée comme un processus ou une combinaison de processus issus de la technologie sous vide et le traitement des tranches de semi-conducteur (S) est effectué sous vide à une pression de moins de 500 Pa, de préférence de moins de 1 Pa et de manière encore préférée de moins de 0,01 Pa.

12. Procédé selon une des revendications 9 à 11, **caractérisé en ce que** les tranches de semi-conducteur (S) sont fournies avec une première structure d'électrode disposée sur un premier côté de la tranche de semi-conducteur, dans lequel la couche (EL) électriquement conductrice est déposée comme une deuxième structure d'électrode sur le deuxième côté de la tranche de semi-conducteur, afin de former une cellule solaire à tranche de semi-conducteur.

13. Procédé selon une des revendications 9 à 11, **caractérisé en ce que** la couche (EL) électriquement conductrice est structurée au moyen d'une étape de structuration en une première structure d'électrode (E1) et une deuxième structure d'électrode (E2), afin de former une cellule solaire à tranche de semi-conducteur.

14. Procédé selon la revendication 9, **caractérisé en ce que** sur la couche mince SiN (AR), une structure d'électrode avant (FE) est appliquée au moyen d'une étape d'impression, laquelle est ensuite cuite en surface au moyen d'une étape de procédé thermique, afin de former une cellule solaire à tranche de semi-conducteur.

15. Procédé selon une des revendications 12 à 14, **caractérisé en ce que** une pluralité de cellules solaires (S) à tranche de semi-conducteur sont couplées électriquement les unes aux autres, fixées sur un élément porteur (3) et encapsulées contre les influences ambiantes au moyen de vitres de verre et/ou de films (30, 31) et/ou d'élément de cadre (32), de telle sorte qu'un module solaire soit formé à partir de la pluralité de cellules solaires à tranches de semi-conducteur (S).
